# EUROPÄISCHE PATENTSCHRIFT

(11) **EP 2 332 174 B1**
(45) Veröffentlichungstag und Bekanntmachung des Hinweises auf die Patenterteilung: **06.09.2017**
(21) Anmeldenummer: 09780108.8
(22) Anmeldetag: 02.07.2009
(51) Int. Cl.: H01L 27/146, H01L 31/09, G01J 5/02, G01J 5/06, G01J 5/20

(54) **THERMISCH ENTKOPPELTES MIKROSTRUKTURIERTES REFERENZELEMENT FÜR SENSOREN**
THERMALLY DECOUPLED MICRO-STRUCTURED REFERENCE ELEMENT FOR SENSORS
ÉLÉMENT DE RÉFÉRENCE MICROSTRUCTURÉ THERMIQUEMENT DÉCOUPLÉ POUR CAPTEURS

(30) Priorität: 02.09.2008 DE 102008041750
(43) Veröffentlichungstag der Anmeldung: 15.06.2011
(73) Patentinhaber: Robert Bosch GmbH, 70442 Stuttgart (DE)
(72) Erfinder: HERRMANN, Ingo, 71292 Friolzheim (DE); HERRMANN, Daniel, 72072 Tübingen (DE); FREUND, Frank, 70439 Stuttgart (DE); FEYH, Ando, 71732 Tamm (DE); ECKARDT, Martin, 70197 Stuttgart (DE)
(86) Internationale Anmeldenummer: PCT/EP2009/058364
(87) Internationale Veröffentlichungsnummer: WO 2010/025973

(56) Entgegenhaltungen:
- EP-A- 0 869 341
- EP-A- 1 296 122
- WO-A-2007/086424
- DE-A1- 19 843 984
- DE-A1-102006 028 435
- US-A1- 2001 035 559
- US-B1- 6 504 153

## Beschreibung

### Stand der Technik

Die Erfindung betrifft eine Sensoranordnung, umfassend ein erfindungsgemäßes Referenzelement sowie ein mikrostrukturiertes Sensorelement mit einer ihren Wert temperaturabhängig verändernden elektrischen Eigenschaft.

Halbleitersensoren können Temperaturänderungen, beispielsweise durch Infrarotstrahlung, über die elektrischen Eigenschaften von Halbleiterbauelementen wie Dioden detektieren. Hierzu benutzen sei üblicherweise Referenzelemente, die durch Designmaßnahmen auf der Temperatur der Sensorsubstrats gehalten werden. Durch eine Differenzbildung der Sensorsignale und der Referenzsignale ist es möglich, auch kleine Veränderungen der Temperatur oder der Infrarotstrahlung bei vergleichsweise großem Offsetsignal zu erfassen. Auch können Störsignale, die durch die Elektronik selbst verursacht werden, eliminiert werden. Solche Störsignale können eine Drift durch eine im Betrieb veränderte Temperatur der Messelektronik sein.

Vom Bauprinzip her sollten die Sensorelemente von den anderen auf dem Sensorsubstrat befindlichen Elementen und vom Substrat selbst elektrisch isoliert und thermisch entkoppelt sein. Die Referenzelemente hingegen sollten elektrisch isoliert, aber thermisch mit dem Substrat gekoppelt sein.

Die thermische Entkopplung der Sensorelemente kann durch Kavitäten, also Hohlräumen unter den Sensorelementen, erfolgen. So offenbart DE 10 2006 028 435 A1 einen Sensor, insbesondere zur ortsaufgelösten Detektion, der aufweist: ein Substrat, mindestens ein mikrostrukturiertes Sensorelement mit einer ihren Wert temperaturabhängig ändernden elektrischen Eigenschaft und mindestens eine Membran oberhalb einer Kaverne, wobei das Sensorelement an der Unterseite der mindestens einen Membran angeordnet ist und wobei das Sensorelement über Zuleitungen kontaktiert ist, die in, auf oder unter der Membran verlaufen. Es können insbesondere mehrere Sensorelemente als Diodenpixel in einer monokristallinen, durch Epitaxie ausgebildeten Schicht ausgebildet sein. In der Membran können Aufhängefedern ausgebildet sein, die die einzelnen Sensorelemente elastisch und isolierend aufnehmen.

Die EP 1 296 122 A2 beschreibt einen Sensor zum Messen einer Temperatur mittels eines auf und/oder unter einer Membran aufgebrachten wärmesensitiven Bereichs, wobei die Membran über einer Aussparung angeordnet ist.

Die US 2001/0035559 A1 beschreibt ein IR-Sensorarray mit eingebauter Temperaturkompensierung.

Die EP 1 978 339 A1 beschreibt IR-Detektoren mit nach außen gerichteten Schichten aus TiN und Si.

Die EP 0 869 341 A1 beschreibt ebenfalls einen IR-Detektor mit nach außen gerichteten Sensorschichten.

Die elektrische Isolierung, aber thermische Kopplung von Referenzelementen in den eingangs beschriebenen Sensoren wird üblicherweise dadurch erreicht, dass die Kavität unter dem Referenzelement weggelassen wird. Hierdurch ist das Element also direkt an das Substrat angebunden. Die elektrisch leitende Verbindung zwischen Substrat und Referenzelement wird durch zusätzliche Dotierungen, beispielsweise durch eine p-dotierte Schicht zwischen zwei n-dotierten Schichten, erreicht. Nachteilig hieran sind jedoch die veränderten elektrischen Eigenschaften des Referenzelements, da es durch die zusätzliche Dotierung nicht mehr äquivalent zu den Sensorelementen ist.

### Offenbarung der Erfindung

Erfindungsgemäß vorgeschlagen wird daher eine Temperatursensoranordnung nach Anspruch 1. Vorteilhafte Weiterbildungen ergeben sich aus den Ansprüchen 2-7. Weiterhin umfasst das Referenzelement eine an der Unterseite der Membran 3 ausgebildete monokristalline Schicht 8 mit mindestens einem pn-Übergang zwischen einem positiv dotierten Bereich 9 und einem negativ dotierten Bereich 10. Hierbei ist es bevorzugt, dass die monokristalline Schicht 8 epitaktisch aufgewachsenes n-dotiertes Silizium umfasst und der pn-Übergang durch p⁺- und n⁺-dotiertes Silizium gebildet wird. Indem die Referenzelemente in einer epitaktischen und somit monokristallinen Schicht ausgebildet werden, kann das Signalrauschen sehr gering gehalten werden. Dieses ist insbesondere bei der Ausbildung von Dioden oder Transistoren vorteilhaft.

Mikrostrukturierte Elemente im Sinne der vorliegenden Erfindung weisen gemäß der üblichen Definition Abmessungen im Mikrometerbereich auf. So können die erfindungsgemäßen Referenzelemente beispielsweise eine Länge, Höhe und/oder Breite von ≥ 1 µm bis ≤ 1000 µm aufweisen.

Als Substrat für die Referenzelemente kommt beispielsweise ein p-Halbleitersubstrat wie p-dotiertes (100)-Silizium in Betracht.

Eine temperaturabhängig veränderliche elektrische Eigenschaft kann unter Anderem der elektrische Widerstand, die Stromstärke des durch das Referenzelement fließenden Stroms oder der Spannungsabfall an dem Referenzelement sein. Vorteilhafterweise ist das Referenzelement eine Halbleiterdiode.

Eine elektrische Isolierung ist gemäß der üblichen Definition zu verstehen und liegt beispielsweise dann vor, wenn ein spezifischer elektrischer Widerstand von mindestens 10¹⁰ Ωm vorliegt.

Die thermische Kopplung zwischen Referenzelement und Substrat ist insbesondere dann gegeben, wenn die durchschnittliche Temperatur T_{R} des Referenzelements während des Betriebes in einem Bereich von ≥ 90% bis ≤ 110 % der durchschnittlichen Temperatur T_{S} des Substrats liegt und wenn während einer Temperaturänderung des Substrats die Temperatur des Referenzelements, in Absolutwerten gesehen, um ≥ 0% bis ≤ 10 % von der Temperatur des Substrats abweicht. Die thermische Kopplung betrifft also sowohl die statische als auch die dynamischer Kopplung von Referenzelement und Substrat.

Die einzelnen Referenzelemente können jedes für sich in einer Kaverne vorgesehen sein oder es können mehrere oder alle Referenzelemente in einer gemeinsamen Kaverne angeordnet sein.

Damit ist ein erfindungsgemäßes Referenzelement elektrisch äquivalent zu auf dem Substrat befindlichen Sensorelementen, aber über die Membran thermisch an das Substrat angebunden. Durch die elektrische Äquivalenz ergibt sich eine höhere Genauigkeit im Differenzverfahren bei der Messung. Weiterhin benötigt man in der Herstellung lediglich gegenüber den Sensorelementen teilweise geänderte Maskenlayouts. Dieses verringert die Herstellungskosten des Sensors. Schließlich durchlaufen Sensor- und Referenzelement während der Herstellung teilweise die gleichen Verfahrensschritte. Auf diese Weise ergeben sich geringere Abweichungen zwischen Sensor- und Referenzelement. Hierdurch steigt die Genauigkeit des Sensors.

Die elektrische Kontaktierung des Referenzelements kann über Zuleitungen erfolgen, die in, auf oder unter der Membran verlaufen.

Die Herstellung des erfindungsgemäßen Referenzelements kann durch oberflächemikromechanische Prozesse erfolgen, so dass lediglich eine Oberfläche zu bearbeiten ist. Man kann hierbei auf Wafer-Ebene arbeiten und die Elemente anschließend vereinzeln. Beispielsweise kann ein erster Bereich eines dotierten Substrats oder einer auf dem Substrat ausgebildeten dotierten Schicht porosifiziert werden, wobei zunächst eine gitterartige Struktur und ein den ersten Bereich umgebender zweiter Bereich durch eine geeigneter Dotierung vor dem nachfolgenden Ätzvorgang geschützt werden. Der erste Bereich unterhalb der gitterartigen Struktur kann somit nachfolgend selektiv elektrolytisch porosifiziert werden, wobei gegebenenfalls auch bereits eine vollständige Entfernung des Materials in diesem Bereich erreicht werden kann. Nachfolgend kann auf der gitterartigen Struktur und dem umliegenden Substrat eine epitaktische Schicht aufgewachsen werden, wobei während des Aufwachsens oder danach eine Temperung des porösen Bereichs unter Ausbildung einer Kaverne erreicht wird.

Gegenstand der Erfindung ist eine Temperatursensoranordnung, umfassend ein Referenzelement sowie ein mikrostrukturiertes Sensorelement mit einer ihren Wert temperaturabhängig verändernden elektrischen Eigenschaft. Solch eine Temperatursensoranordnung kann beispielsweise in einem Diodenarray zur ortsaufgelösten Temperaturmessung verwirklicht sein. Weitere mögliche Anwendungsgebiete sind die ortsaufgelöste spektroskopische Messung einer Gaskonzentration oder der Einsatz in Fingerabdrucksensoren. Die elektrischen Zuleitungen zu den Referenzelementen können an gemeinsame Zuleitungen angeschlossen werden, so dass die einzelnen Bauteile über eine sukzessive Adressierung ausgelesen werden können. Durch die hohe Integration ist nur noch eine geringe Leistungsaufnahme erforderlich.

Ein Beispiel, das hilfreich für das Verständnis der Erfindung ist, ist ein Verfahren zum Betrieb eines Temperatursensors, wobei ein mikrostrukturiertes Sensorelement mit einer ihren Wert temperaturabhängig verändernden elektrischen Eigenschaft die zu messende Temperatur bestimmt und wobei ein Referenzelement gemäß der vorliegenden Erfindung zur Referenzierung herangezogen wird. Auf diese Weise ergeben sich geringere Abweichungen zwischen Sensor- und Referenzelement. Hierdurch steigt die Genauigkeit des Sensors.

Die Erfindung wird unter Bezugnahme auf die Zeichnungen weiter erläutert. Hierbei zeigen:
FIG. 1 eine Querschnittsansicht eines Referenzelements, das Teil einer erfindungsgemäßen Temperatursensoranordnung ist.
FIG. 2 eine Draufsicht auf ein Referenzelement, das Teil einer erfindungsgemäßen Temperatursensoranordnung ist.

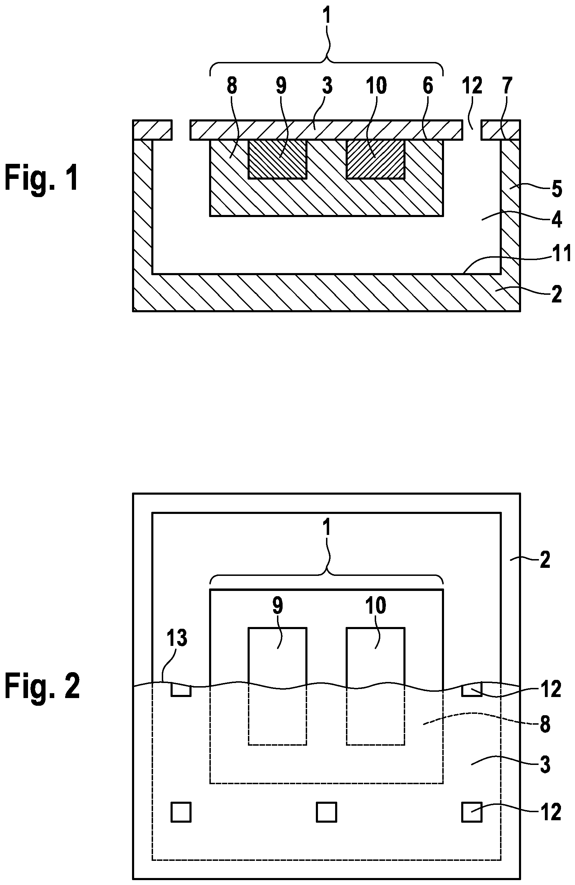

FIG. 1 zeigt eine Querschnittsansicht eines Referenzelements, das Teil einer erfindungsgemäßen Temperatursensoranordnung ist. Das Referenzelement 1 befindet sich auf einem Substrat 2 und hierin auf der Unterseite einer dielektrischen Membran 3. Weiterhin ist zwischen dem Referenzelement 1 und dem Substrat 2 eine umlaufende Kaverne 4 angeordnet. Dieses bedeutet, dass zumindest um den seitlichen Rand des Referenzelements herum kein direkter Kontakt zwischen dem Referenzelement 1 und dem Substrat 2 besteht. Hierdurch erreicht man eine elektrische Isolierung. Die Kaverne 4 wird an ihrem äußeren Rand durch die Seitenwände 5 begrenzt. Die Membran 3 kontaktiert sowohl die Seitenwände 5 der Kaverne 4 und somit das Substrat 2 als auch das Referenzelement. So wird die Kaverne 4 auch durch die Membran 3 nach oben hin begrenzt.

Erfindungsgemäß ist vorgesehen, dass die durch die Membran 3 abgedeckte Fläche des Referenzelements 1 ≥ 10% bis ≤ 100% der möglichen abdeckbaren Fläche beträgt. Die Abdeckung kann auch in einem Bereich von ≥ 60% bis ≤ 95% oder von ≥ 70% bis ≤ 90% liegen. Es ist möglich, dass unterhalb der Membran 3 Kontaktierungen für Bestandteile des Referenzelements verlaufen. So lässt sich beispielsweise ein Abdeckungsgrad von 100% verwirklichen. Die mögliche abdeckbare Fläche des Referenzelements 1 ist der Teil der Oberfläche des Referenzelements 1, welche der Membran 3 zugewandt ist und welche aufgrund der geometrischen Gegebenheiten wie zum Beispiel Koplanarität auch von der Membran 3 kontaktiert werden kann. Insgesamt wird also angestrebt, durch die angegebenen Abdeckungen die thermische Kopplung zwischen Referenzelement 1 und Membran 3 und somit Substrat 2 unter Berücksichtigung von eventuellen sonstigen Designeinschränkungen so groß wie möglich zu gestalten.

Erfindungsgemäß ist weiter vorgesehen, dass die durch die Membran 3 abgedeckte Oberfläche der Kaverne 4 ≥ 50% bis ≤ 100% der möglichen abdeckbaren Oberfläche beträgt. Die Abdeckung kann auch in einem Bereich von ≥ 60% bis ≤ 95% oder von ≥ 70% bis ≤ 90% liegen. Die abdeckbare Oberfläche der Kaverne 4 ist die gedachte Oberfläche der Kaverne 4, welche zwischen den Seitenwänden 5 und dem Referenzelement 1 liegt und daher auch von der Membran 3 abgedeckt werden kann. Insgesamt wird also angestrebt, durch die angegebenen Abdeckungen den thermischen Kopplungsweg zwischen Referenzelement 1 und Membran 3 und somit Substrat 2 unter Berücksichtigung von eventuellen sonstigen Designeinschränkungen so groß wie möglich zu gestalten.

Weiterhin ist erfindungsgemäß vorgesehen, dass der der Membran 3 zugewandte Rand 6 des Referenzelements 1 zu ≥ 50% bis ≤ 100% seines Umfangs von der Membran 3 kontaktiert wird. Die Kontaktierung kann auch in einem Bereich von ≥ 60% bis ≤ 95% oder von ≥ 70% bis ≤ 90% liegen. Hierdurch soll erreicht werden, dass der Übergang zwischen dem Abschnitt Membran 3 über der Kaverne 4 und dem Abschnitt der Membran 3 über dem Referenzelement 1 nicht nur punktförmig ist, was eine schlechte thermische Kopplung zur Folge hätte. Vielmehr soll mit in den angegebenen Kontaktierungswerten der thermische Kopplungsweg zwischen Referenzelement 1 und Membran 3 und somit Substrat 2 unter Berücksichtigung von eventuellen sonstigen Designeinschränkungen so groß wie möglich zu gestaltet werden.

Schließlich ist erfindungsgemäß vorgesehen, dass die der Membran 3 zugewandten Abschnitte 7 der Seitenwände 5 der Kaverne zu ≥ 50% bis ≤ 100 % des möglichen Ausmaßes von der Membran 3 kontaktiert werden. Die Kontaktierung kann auch in einem Bereich von ≥ 60% bis ≤ 95% oder von ≥ 70% bis ≤ 90% liegen. Hierdurch soll erreicht werden, dass der Übergang zwischen dem Abschnitt Membran 3 über der Kaverne 4 und dem Abschnitt der Membran 3 über dem Substrat 2 nicht nur punktförmig ist, was eine schlechte thermische Kopplung zur Folge hätte. Vielmehr soll mit in den angegebenen Kontaktierungswerten der thermische Kopplungsweg zwischen Referenzelement 1 und Membran 3 und somit Substrat 2 unter Berücksichtigung von eventuellen sonstigen Designeinschränkungen so groß wie möglich gestaltet werden. In einer Ausführungsform des Referenzelements ist die Membran als Teilbereich einer oder mehrerer dielektrischer Schichten ausgebildet. Beispielsweise kann ein anderer Teil des Schichtenverbunds ein Material zur Absorption von IR-Strahlung sein.

In einer weiteren Ausführungsform des Referenzelements wird innerhalb des Substrats 2 der Boden 11 der Kaverne 4 gebildet. Anders ausgedrückt ist die Kaverne nach unten hin durch das Substrat begrenzt. Diese Variante ist in FIG. 1 auch dargestellt.

In einer weiteren Ausführungsform des Referenzelements wird die Kaverne 4 durch das Substrat 2 hindurch gebildet. Diese Variante ist nicht in FIG. 1 dargestellt. Hierbei ist die Kaverne 4 zumindest teilweise eine durchgehende Kaverne, also unten offen.

In einer weiteren Ausführungsform des Referenzelements weist die Membran 3 durchgehende Öffnungen 12 zur Kaverne 4 auf. Durch diese Öffnungen oder Ätzzugänge kann ein Ätzmittel auf Substratmaterial unterhalb der Membran 3 einwirken, wodurch die Kaverne gebildet wird.

In einer weiteren Ausführungsform des Referenzelements umfasst das Material der Membran 3 Siliziumdioxid. So kann die Membran durch etablierte Prozesse in der Halbleiter- und Mikrosystemtechnik aufgebaut werden, beispielsweise durch Oxidation nach dem LOCOS-Verfahren.

FIG. 2 zeigt eine Draufsicht auf ein erfindungsgemäßes Referenzelement. Die Anordnung wird vom Substrat 2 getragen. Weite Teile des Substrats 2 sind von der Membran 3 bedeckt. Durch die Membran 3 hindurch verlaufen Öffnungen oder Ätzzugänge 12 an verschiedenen Stellen der Membran 3. Unter dem Membran liegende Teile von Baugruppen des Referenzelements 1 sind gestrichelt dargestellt. Entlang der Linie 13 wurde zur zeichnerischen Verdeutlichung ein Teil der Membran 3 entfernt. Die so freigelegten Teile von Baugruppen des Referenzelements 1 sind mit durchgezogenen Linien gezeichnet. Man erkennt also, dass unterhalb der Membran 3 die monokristalline Schicht 8 mit darin eingebettetem positiv dotiertem Bereich 9 und negativ dotiertem Bereich 10 liegen.

## Patentansprüche

1. Temperatursensoranordnung, umfassend ein mikrostrukturiertes Sensorelement mit einer ihren Wert temperaturabhängig verändernden elektrischen Eigenschaft zur Bestimmung einer zu messenden Temperatur, ein Substrat (2), eine dielektrische Membran (3) und ein mikrostrukturiertes Referenzelement (1) zur Referenzierung der mittels des mikrostrukturierten Sensorelements zu messenden Temperatur, wobei das Referenzelement (1) eine ihren Wert temperaturabhängig verändernde elektrische Eigenschaft aufweist,
das Referenzelement (1) gegenüber dem Substrat (2) elektrisch isoliert und thermisch gekoppelt vorliegt und das Sensorelement, gegenüber dem Substrat (2) elektrisch isoliert ist und vom Substrat (2) thermisch entkoppelt vorliegt,
das Referenzelement (1) an der Unterseite der dielektrischen Membran (3) angeordnet ist, wobei die Unterseite dem Substrat (2) gegenüberliegt,
zwischen Referenzelement (1) und Substrat (2) eine umlaufende und weiterhin durch die Membran begrenzte Kaverne (4) mit Seitenwänden (5) angeordnet ist und
die Membran (3) mit dem Substrat (2) verbunden ist, wobei die durch die Membran (3) abgedeckte Fläche des Referenzelements (1) ≥ 10% bis ≤ 100% der möglichen abdeckbaren Fläche beträgt,
die durch die Membran (3) abgedeckte Oberfläche der Kaverne (4) ≥ 50% bis ≤ 100% der möglichen abdeckbaren Oberfläche beträgt,
der der Membran (3) zugewandte Rand (6) des Referenzelements (1) zu ≥ 50% bis ≤ 100% seines Umfangs von der Membran (3) kontaktiert wird und die der Membran (3) zugewandten Abschnitte (7) der Seitenwände (5) der Kaverne zu ≥ 50% bis ≤ 100% des möglichen Ausmaßes von der Membran (3) kontaktiert werden und
wobei das Referenzelement (1) eine an der Unterseite der dielektrischen Membran (3) ausgebildete monokristalline Schicht (8) mit mindestens einem pn-Übergang zwischen einem positiv dotierten Bereich (9) und einem negativ dotierten Bereich (10) umfasst.

2. Sensoranordnung gemäß Anspruch 1, wobei die Membran (3) als Teilbereich einer oder mehrerer dielektrischer Schichten ausgebildet ist.

3. Sensoranordnung gemäß Anspruch 1, wobei die monokristalline Schicht (8) epitaktisch aufgewachsenes n-dotiertes Silizium umfasst und der pn-Übergang durch p⁺- und n⁺-dotiertes Silizium gebildet wird.

4. Sensoranordnung gemäß einem der Ansprüche 1 bis 3, wobei innerhalb des Substrats (2) der Boden (11) der Kaverne (4) gebildet wird.

5. Sensoranordnung) gemäß einem der Ansprüche 1 bis 3, wobei die Kaverne (4) durch das Substrat (2) hindurch gebildet wird.

6. Sensoranordnung gemäß einem der Ansprüche 1 bis 5, wobei die Membran (3) durchgehende Öffnungen (12) zur Kaverne (4) aufweist.

7. Sensoranordnung gemäß einem der Ansprüche 1 bis 6, wobei das Material der Membran (3) Siliziumdioxid umfasst.

## Claims

1. Temperature sensor arrangement, comprising a microstructured sensor element having an electrical property varying its value in a temperature-dependent manner for determining a temperature to be measured, a substrate (2), a dielectric membrane (3) and a microstructured reference element (1) for referencing the temperature to be measured by means of the microstructured sensor element,
wherein the reference element (1) has an electrical property varying its value in a temperature-dependent manner,
the reference element (1) is present in an electrically insulated and thermally coupled fashion with respect to the substrate (2), and the sensor element is electrically insulated with respect to the substrate (2) and is present in a manner thermally decoupled from the substrate (2),
the reference element (1) is arranged on the underside of the dielectric membrane (3), wherein the underside is situated opposite the substrate (2),
a circumferential cavity (4) having side walls (5) and furthermore delimited by the membrane is arranged between reference element (1) and substrate (2) and
the membrane (3) is connected to the substrate (2), wherein
the area of the reference element (1) that is covered by the membrane (3) is ≥ 10% to ≤ 100% of the possible area that can be covered,
the surface of the cavity (4) that is covered by the membrane (3) is ≥ 50% to ≤ 100% of the possible surface that can be covered,
the edge (6) of the reference element (1) that faces the membrane (3) is contacted by the membrane (3) over ≥ 50% to ≤ 100% of its extent, and
the portions (7) of the side walls (5) of the cavity that face the membrane (3) are contacted by the membrane (3) over ≥ 50% to ≤ 100% of the possible extent, and
wherein the reference element (1) comprises a monocrystalline layer (8) formed on the underside of the dielectric membrane (3) and having at least one pn junction between a positively doped region (9) and a negatively doped region (10).

2. Sensor arrangement according to Claim 1, wherein the membrane (3) is embodied as a partial region of one or a plurality of dielectric layers.

3. Sensor arrangement according to Claim 1, wherein the monocrystalline layer (8) comprises n-doped silicon grown epitaxially and the pn junction is formed by p⁺- and n+-doped silicon.

4. Sensor arrangement according to any of Claims 1 to 3, wherein the bottom (11) of the cavity (4) is formed within the substrate (2).

5. Sensor arrangement according to any of Claims 1 to 3, wherein the cavity (4) is formed through the substrate (2).

6. Sensor arrangement according to any of Claims 1 to 5, wherein the membrane (3) has continuous openings (12) to the cavity (4).

7. Sensor arrangement according to any of Claims 1 to 6, wherein the material of the membrane (3) comprises silicon dioxide.

## Revendications

1. Système de capteur de température, comprenant un élément capteur microstructuré ayant une propriété électrique dont la valeur varie en fonction de la température pour la détermination d'une température à mesurer, un substrat (2), une membrane diélectrique (3) et un élément de référence microstructuré (1) pour déterminer une référence pour la température à mesurer au moyen de l'élément capteur microstructuré, dans lequel l'élément de référence (1) présente une propriété électrique dont la valeur varie en fonction de la température,
l'élément de référence (1) est isolé électriquement et est présent de manière couplée thermiquement par rapport au substrat (2) et l'élément capteur est isolé électriquement par rapport au substrat (2) et est présent de manière thermiquement découplée du substrat (2),
l'élément de référence (1) est disposé sur la face inférieure de la membrane diélectrique (3), dans lequel la face inférieure est opposée au substrat (2),
une cavité (4) circonférentielle ayant des parois latérales (5) et par ailleurs délimitée par la membrane est disposée entre l'élément de référence (1) et le substrat (2) et
la membrane (3) est reliée au substrat (2), dans lequel la surface de l'élément de référence (1) recouverte par la membrane (3) va de ≥ 10% à ≤ 100% de la surface pouvant possiblement être recouverte,
la surface de la cavité (4) recouverte par la membrane (3) va de ≥ 50% à ≤ 100% de la surface pouvant possiblement être recouverte,
le bord (6) tourné vers la membrane (3) de l'élément de référence (1) est mis en contact avec la membrane (3) sur ≥ 50% à ≤ 100% de sa circonférence et
les parties (7) des parois latérales (5) de la cavité tournées vers la membrane (3) sont mises en contact avec la membrane (3) sur ≥ 50% à ≤ 100% de la dimension possible et
dans lequel l'élément de référence (1) comprend une couche monocristalline (8) réalisée sur la face inférieure de la membrane diélectrique (3) avec au moins une transition pn entre une région dopée positivement (9) et une région dopée négativement (10).

2. Système de capteur selon la revendication 1, dans lequel la membrane (3) est réalisée sous la forme d'une section d'une ou plusieurs couches diélectriques.

3. Système de capteur selon la revendication 1, dans lequel la couche monocristalline (8) comprend du silicium dopé n formé par croissance épitaxiale et la transition pn est formée par du silicium dopé p+ et n+.

4. Système de capteur selon l'une quelconque des revendications 1 à 3, dans lequel le fond (11) de la cavité (4) est formé à l'intérieur du substrat (2).

5. Système de capteur selon l'une quelconque des revendications 1 à 3, dans lequel la cavité (4) est formée à travers le substrat (2).

6. Système de capteur selon l'une quelconque des revendications 1 à 5, dans lequel la membrane (3) comporte des ouvertures traversantes (12) débouchant dans la cavité (4).

7. Système de capteur selon l'une quelconque des revendications 1 à 6, dans lequel le matériau de la membrane (3) comprend du dioxyde de silicium.
